# EUROPÄISCHE PATENTSCHRIFT

(11) **EP 3 274 154 B1**
(45) Veröffentlichungstag und Bekanntmachung des Hinweises auf die Patenterteilung: **26.02.2020**
(21) Anmeldenummer: 16711595.5
(22) Anmeldetag: 21.03.2016
(51) Int. Cl.: B29C 65/34, B29C 65/50, B29K 101/12

(54) **BAUTEILANORDNUNG UND VERFAHREN ZUM WIDERSTANDSSCHWEISSEN THERMOPLASTISCHER BAUTEILE**
COMPONENT ARRANGEMENT AND METHOD FOR RESISTANCE WELDING OF THERMOPLASTIC COMPONENTS
ENSEMBLE D'ÉLÉMENTS ET PROCÉDÉ DE SOUDAGE PAR RÉSISTANCE D'ÉLÉMENTS THERMOPLASTIQUES

(30) Priorität: 27.03.2015 DE 102015205656
(43) Veröffentlichungstag der Anmeldung: 31.01.2018
(73) Patentinhaber: Bayerische Motoren Werke Aktiengesellschaft, 80809 München (DE)
(72) Erfinder: FREUDENBERG, Timm, 80337 München (DE); HAHN, Wolfgang, 85238 Petershausen (DE); SCHÜRMANN, Helmut, 67133 Maxdorf (DE)
(86) Internationale Anmeldenummer: PCT/EP2016/056074
(87) Internationale Veröffentlichungsnummer: WO 2016/156073

(56) Entgegenhaltungen:
- WO-A1-02/17687
- DE-U1- 8 900 663
- FR-A1- 2 516 439
- FR-A1- 2 868 007
- GB-A- 2 327 992
- JP-A- 2009 270 684
- US-A- 3 907 625
- US-A- 6 004 418
- US-A1- 2002 038 800

## Beschreibung

Die Erfindung betrifft eine Bauteilanordnung und ein Verfahren zum Widerstandschweißen thermoplastischer Bauteile.

Beim Widerstandsschweißen thermoplastischer Bauteile mittels Widerstandselement wird ein Widerstandselement in die Fügezone der zu fügenden Bauteile eingelegt. Nach Zusammenführung der Fügepartner wird eine elektrische Leistung in das Widerstandselement eingebracht, so dass das umgebende thermoplastische Material in der Fügezone aufschmilzt. Nach Abkühlung der Schmelze und Aufbringen eines Fügedrucks liegt eine stoffschlüssige Verbindung der Fügepartner vor. Das Widerstandselement verbleibt in der Fügezone.

Das Widerstandsschweißen mittels Widerstandselement stellt ein werkstoffgerechtes Fügeverfahren für faserverstärkte sowie unverstärkte Thermoplaste dar. Es lassen sich stoffschlüssige, großflächige Verbindungen mit hohen Festigkeiten verwirklichen. Eine entscheidende Rolle nimmt dabei die Gestaltung der Fügezone ein. Durch Einbringen eines geeigneten elektrischen Widerstandselementes dürfen die mechanischen Eigenschaften des Verbundes nicht negativ beeinflusst werden und es muss ein gleichmäßiger Wärmeeintrag erfolgen.

Um diesen Anforderungen Rechnung zu tragen, werden bislang metallische Drahtgewebe und/oder gewickelte Einzeldrähte eingesetzt. Diese werden direkt auf das Bauteil oder auf ein Trägermaterial in der Fügezone abgelegt. So sind beispielsweise von A. Yousefpour, M.-A. Octeau, M. Hojjati: "Resistance Welding of Thermoplastic Composites using Metal Mesh Heating Elements", Joining Plastics 2006, Paper 11, Edelstahlgewebe mit unterschiedlichen Maschenweiten zum Widerstandschweißen von kohlenstofffaser-verstärkten Verbundkunststoffen (APC-2/AS4) untersucht worden.

Mit metallischen Einzeldrähten sowie Geweben sind prozesssicher hohe Fügenahtqualitäten möglich. So zeigt z.B. die Druckschrift GB 2 327 992 A ein Widerstandheizelement in Form einer thermoplastischen Kunststofffolie mit darauf angeordnetem Heizdraht, das verwendet wird um ein Rohr und ein Anschlussstück miteinander zu verschweißen.

Jedoch ist der Einsatz dieser Widerstandselemente vornehmlich einfachgekrümmten Fügegeometrien vorbehalten, aufgrund eingeschränkter Drapierbarkeit der Schweißhalbzeuge. Außerdem ist man durch die Verfügbarkeit gefertigter Halbzeuge auf vorgegebene Geometrien (Drahtdurchmesser, Maschenweiten,...) beschränkt und damit in der Flexibilität limitiert. Des Weiteren entstehen durch die Verwendung metallischer Halbzeuge Zusatzkosten.

Weiterhin sind Widerstandselemente bekannt, welche ein Trägersubstrat in Form einer thermoplastischen Kunststofffolie und eine darauf ausgebildete Leiterbahnstruktur aufweisen. So zeigt z.B. die Druckschrift FR 2 868 007 A1 ein derartiges Widerstandselement, das genutzt wird um ein Rohr mit einem Anschluss zu verschweißen. Zunächst wird das Widerstandselement hergestellt, dann in eine Form eingelegt und mit Kunststoff umgossen, wodurch der Anschluss hergestellt wird und gleichzeitig das Widerstandselement in den Anschluss integriert wird. Anschluss und Rohr werden zueinander positioniert und verschweißt, indem ein Strom durch das Widerstandselement geleitet wird. Auch die Druckschriften US 3 907 625 A, JP 2009 270684 A und FR 2 516 439 A1 zeigen derartige Widerstandselemente, welche verwendet werden im Rohre miteinander oder mit Anschlusselementen zu verbinden.

Das Prinzip der Widerstandserwärmung wird weiterhin genutzt, um Lebensmittel zu erwärmen, wie beispielsweise aus den Druckschriften WO 02/17687 A1 und US 2002/0038800 A1 bekannt. Die dort verwendeten Heizanordnungen weisen Widerstandselemente auf mit einem Trägersubstrat, auf dem Leiterbahnstrukturen aufgebracht sind.

Weiterhin werden derartige Widerstandselemente auch verwendet um Klebstoffe zu aktivieren. So zeigt die Druckschrift US 6 004 418 A ein Verfahren zur Herstellung eines Sitzkissens bzw. einer Rückenlehne für einen Kraftfahrzeugsitz. Um ein Bezugsmaterial mit dem Schaumkern des Sitzes zu verkleben, wird eine Klebstoffschicht, welche zwischen Bezugsmaterial und Schaumkern angeordnet ist, mittels Widerstandselement erwärmt und aktiviert. Die Klebstoffschicht kann durch einen thermoplastischen Kunststoff gebildet werden.

Weitere Widerstandswerkstoffe können Endlos-Kohlenstofffasern als Gelege und Gewebe sein. Auch die Verwendung leitfähiger Compounds, Kohlenstofffasern (Kurz- und Langfasern) sowie Kohlenstofffaser-Vliese ist denkbar, jedoch schwierig in der Praxis umzusetzen.

Nachteilig an den bekannten Widerstandselementen ist, dass sich mit Kohlenstoff-Kurz- und -Langfasern sowie mit leitfähigen Compounds eine gleichmäßige Erwärmung nur schwierig realisieren lässt, da eine homogene Verteilung der elektrisch leitenden Partikel nur mit erheblichem Aufwand möglich ist. Mit Endlos-Kohlenstofffasern lassen sich zwar grundsätzlich gute Schweißergebnisse mit hohen Festigkeiten erzielen, jedoch erweist sich eine gleichmäßige elektrische Kontaktierung des Widerstandselements als problematisch - insbesondere bei großen Kontaktierungslängen.

Bei Kohlenstofffaser(CF)-Geweben ist durch den Halbzeugaufbau aus Kett- & Schussfäden eine Quervernetzung der elektrisch leitenden Fasern gegeben, wodurch die gleichmäßige elektrische Kontaktierung weniger kritisch ist.

Aufgabe der vorliegenden Erfindung ist es deshalb, eine Bauteilanordnung und ein Verfahren zum Widerstandsschweißen anzugeben, das die Nachteile bekannter Verfahren vermeidet und mit dem eine zuverlässige und gleichmäßige Verschweißung auch komplexer Füge-Geometrien gewährleistet werden kann. Gelöst wird diese Aufgabe durch eine Bauteilanordnung nach Patentanspruch 1 und ein Verfahren nach Patentanspruch 12. Weitere vorteilhafte Ausgestaltungen der Erfindung ergeben sich aus den Unteransprüchen.

Ein Widerstandselement, das zum Ausbilden einer Widerstandsschweißverbindung zwischen einem ersten und mindestens einem zweiten thermoplastischen Bauteil angeordnet werden kann, weist eine auf einem Trägersubstrat ausgebildete Leiterbahnstruktur mit zumindest einem Heizabschnitt und Anschlussabschnitten auf, wobei der Heizabschnitt durch Einbringen einer elektrischen Leistung erwärmt werden kann, so dass umgebendes Kunststoffmaterial aufgeschmolzen werden kann.

Der Erfindung liegt somit die Idee zugrunde, anstelle der bislang bekannten Halbzeuge eine Leiterbahnstruktur einzusetzen. Die Leiterbahnstruktur kann eine oder mehrere miteinander verschaltete Leiterbahnen aufweisen. Die Leiterbahnstruktur ermöglicht eine nahezu uneingeschränkte Freiheit in der Ausgestaltung des Widerstandselements und bietet hierdurch vielfältige Möglichkeiten den Energieeintrag in die Fügezone gezielt einzustellen. Durch entsprechende Wahl der Dimensionen der Leiterbahnen, der verwendeten Materialien und des Designs des Leiterbahnbildes lassen sich Widerstandselemente für die unterschiedlichsten Fügeflächen realisieren. Es lassen sich komplexe Geometrien auch auf dreidimensionalen Oberflächen realisieren. Durch geeignete Gestaltung des Leiterbahnbildes lassen sich auch große Fügeflächen realisieren.

Die Leiterbahnstruktur weist Anschlussabschnitte auf, die der elektrischen Kontaktierung des Widerstandselements zum Einbringen der für das Schweißen benötigten elektrischen Energie dienen. Die Anschlussabschnitte leiten den Strom in den Heizabschnitt der Leiterstruktur weiter. Der Heizabschnitt ist der Abschnitt der Leiterbahnstruktur, in dem während der Schweißung durch Joule'sche Verluste eine nennenswerte Erwärmung (d.h. eine Erwärmung, die ausreicht, um den umgebenden Kunststoff in die schmelzflüssige Phase zu überführen) stattfindet.

Die Leiterbahnstruktur wird auf einem Trägersubstrat ausgebildet. In einer nicht erfindungsgemäßen Ausgestaltung kann eines der zu verschweißenden Bauteile als Trägersubstrat dienen, d.h. die Leiterbahnstruktur wird auf dem Bauteil ausgebildet. Dies ermöglicht eine besonders einfache und genaue Positionierung der Leiterbahnstruktur. Die Leiterbahnstruktur kann in dieser Ausgestaltung direkt auf dem Bauteil ausgebildet werden, oder es können zunächst eine oder mehrere weitere Materialschichten, wie z.B. ein Haftvermittler, auf dem Bauteil ausgebildet werden.

In einer erfindungsgemäßen Ausgestaltung ist das Trägersubstrat eine thermoplastische Kunststofffolie. Die Leiterbahnstruktur wird auf dieser Folie ausgebildet und mit der Folie auf einem der zu verschweißenden Bauteile abgelegt. Vorteilhafter Weise stellt die Folie dabei ein flexibles Trägermaterial bereit, das es ermöglicht, die Leiterbahnstruktur im ebenen Zustand auszubilden und anschließend auf dreidimensionalen Fügestrukturen abzulegen. Darüber hinaus kann die Folie als Zusatzwerkstoff im Schweißprozess dienen, um in der Fügezone ausreichend Kunststoffmatrix bereitzustellen. Hierzu wird das Material der Folie vorzugsweise so ausgewählt, dass es mit dem Material bzw. dem Matrixmaterial der zu verschweißenden Fügepartner verträglich ist, wie z.B. PA6 mit PA6.6. Weiterhin erzielt die Folie Vorteile, wenn das Bauteil elektrisch leitfähige Partikel enthält. Dann wirkt die Folie als elektrische Isolationsschicht zwischen Leiterbahn und Bauteil und verhindert unerwünschte Nebenschlüsse während des Schweißprozesses.

Die Leiterbahnstruktur kann mit herkömmlichen Verfahren zur Erzeugung gedruckter Elektronik hergestellt werden. Hierunter werden im Rahmen dieser Erfindung nicht nur die Druckverfahren im klassischen Sinne, sondern explizit auch Prägeverfahren, wie das Heißprägen oder die Laser(direkt)strukturierung verstanden.

Durch die Herstellung der Leiterbahnstruktur mittels Druckverfahren wie z.B. Siebdruck, Flexodruck, Tampondruck, Tintenstrahldruck u.ä., ist in einer Ausgestaltung der Erfindung eine besonders wirtschaftliche Herstellung möglich, da keine Abfallprodukte anfallen und keine teuren Halbzeuge erworben werden müssen. Für die Herstellung mittels Druckverfahren eignen sich elektrisch leitfähige Tinten, wie z.B. Polymer-Dickschicht Tinten, insbesondere Silber-, Kupfer-, Aluminium-, Eisen- und Graphittinten. Gegebenenfalls kann nach dem ein- oder mehrstufigen Druckprozess noch ein Tempern der Leiterbahnen erfolgen. Mit gedruckten Leiterbahnstrukturen lassen sich stabile Fügeverbindungen erreichen. Durch eine geeignete Wahl des Fügedrucks kann ein Verschwimmen der Leiterbahnstrukturen während des Schweißprozesses gezielt herbeigeführt werden, wodurch die Anbindung der Fügepartner verbessert werden kann. Für die Direktbedruckung von dreidimensionalen Fügestrukturen wird der Tampondruck bevorzugt.

In einer Ausgestaltung wird die Leiterbahnstruktur mittels Heißprägen hergestellt. Hierzu wird eine Folie mit einer leitenden Schicht (und ggf. weiteren Schichten, wie z.B. Klebeschicht) auf das Bauteil aufgelegt. Unter Druck und Temperatur wird die Folie mittels eines Stempels in Form der gewünschten Struktur auf bzw. in das Bauteil geprägt. Die überschüssige ausgestanzte Folie wird entfernt. Die leitende Schicht der Folie wird insbesondere durch eine metallische Schicht, vorzugsweise eine Silber- oder Kupferschicht, oder durch eine Kohlenstoffschicht gebildet. Ein so hergestelltes Widerstandselement zeichnet sich durch hohe Prozesssicherheit aus. Die Leiterbahnstruktur verfügt über eine größere Homogenität als eine mittels Druckverfahren ausgebildete Leiterbahnstruktur. Es lassen sich schmale Leiterbahnen mit größeren Schichtdicken ausbilden, wodurch sich große offene Fügeflächen realisieren lassen. Außerdem bleibt die Leiterbahnstruktur während des Schweißverfahrens erhalten, somit ist ein späteres Auftrennen der Bauteile durch ein erneutes Aufschmelzen der Fügezone möglich.

Die Leiterbahnstruktur ermöglicht es, entsprechend den Fügeanforderungen individuell einstellbare Erwärmungsbilder in der Fügezone zu erzeugen. Hierbei ist das Erwärmungsbild sowie die Prozesssicherheit maßgebend durch die Art des Trägersubstrats, das Herstellungsverfahren der Leiterbahnstruktur, die Zusammensetzung und den Aufbau der eingesetzten Tinte bzw. Prägefolie, die Dimension der gedruckten Leiterbahnen, insbesondere Dicke und Breite, sowie das Design des Druckbildes bestimmt.

Die Leiterbahnstruktur kann z.B. durch eine einzige Leiterbahn gebildet werden, wobei die Leiterbahn vielfältige Verläufe im Heizabschnitt aufweisen kann, z.B. einen mäanderförmigen Verlauf mit beliebigen Abständen und Radien, schneckenförmige Anordnungen etc.

Die im Heizabschnitt ausgebildete Leiterbahn bzw. Leiterbahnen sollen zu einer ausreichenden Erwärmung des umgebenden Materials, d.h. zum Erreichen der Schmelztemperatur des Kunststoffmaterials führen. Die Schmelztemperatur kann je nach verwendetem Kunststoffmaterial schwanken. Für Polyamid liegt sie bei ca. 230°C, während für PEEK Temperaturen um 380°C notwendig sind. Die Leiterbahnbreite und Dicke wird in Abhängigkeit der erforderlichen Temperaturen bzw. des notwendigen Energieeintrags gewählt. Vorzugsweise wird die Leiterbahnbreite kleiner als 400 Mikrometer, besonders bevorzugt kleiner als 300 Mikrometer gewählt, bei einer Leiterbahndicke von vorzugsweise 50 Mikrometer oder weniger.

In einer Ausgestaltung weist der Heizabschnitt des Widerstandselements zwei oder mehrere parallel geschaltete Leiterbahnen auf, wodurch redundante Strompfade als Sicherheit gegen Leiterbahnfehlstellen bereitgestellt werden und die Prozesssicherheit gesteigert werden kann.

In einer bevorzugten Ausgestaltung weist die Leiterbahnstruktur zur weiteren Steigerung der Prozesssicherheit im Heizabschnitt weiterhin mindestens eine Querverbindung zwischen den parallel geschalteten Leiterbahnen auf.

Bei herkömmlichen Widerstandselementen in Form von Drahtgeflechten erweisen sich die Randbereiche der Fügezone häufig als problematisch. Durch eine erhöhte Wärmeabfuhr kann es hier zu einer ungenügenden Erwärmung und infolge dessen zu einer mangelnden Aufschmelzung kommen. Dem wird vorteilhafter Weise in einer Ausgestaltung der Erfindung vorgebeugt, bei der die Leiterbahnstruktur im Heizabschnitt so ausgebildet ist, dass die Wärmeentwicklung in einem Randgebiet des Heizabschnitts gegenüber der Heizabschnittmitte erhöht ist. Hierdurch wird der Wärmeeintrag in einem Randgebiet der Fügezone gegenüber der Fügezonenmitte erhöht. Dies kann z.B. dadurch realisiert werden, dass die Leiterbahnen im Randbereich der Fügezone einen verringerten Abstand voneinander haben oder in der Fügezonenmitte einen vergrößerten Querschnitt aufweisen. Die Querschnittsvergrößerung kann beispielsweise durch Variation der Tintenmenge oder -beschaffenheit, durch lokal begrenztes Aufdrucken zusätzlicher Leitbahnschichten (Variation der Leiterbahndicke) oder Variation der Leiterbahnbreite erfolgen.

Vorteilhafter Weise kann das gleichzeitige Verschweißen mehrerer Fügestellen mit nur einem Widerstandselement ermöglicht werden, indem das Widerstandselement in einer Ausgestaltung zwei oder mehr seriell geschaltete Heizabschnitte aufweist. Die Heizabschnitte sind vorzugsweise durch einen oder mehrere Verbindungsabschnitte elektrisch miteinander verbunden. In den Verbindungsabschnitten ist die Leiterbahnstruktur mit einem geringeren Widerstand ausgestaltet, so dass während des Schweißverfahrens keine nennenswerte Erwärmung der Verbindungsabschnitte durch elektrische Verluste stattfindet, insbesondere bleibt die Leiterbahnstruktur im Verbindungsabschnitt unterhalb der Schmelztemperatur der zu fügenden thermoplastischen Materialien. Die Heizabschnitte können gleich bzw. unterschiedlich gestaltet sein, z.B. unterschiedliche Leiterbahnabmessungen und/oder-anordnungen aufweisen oder aus unterschiedlichen Werkstoffen bestehen. Mit diesem Widerstandselement können zwei Bauteile an mehreren Fügestellen gleichzeitig verschweißt werden oder es können mehrere Bauteile gleichzeitig an ein Bauteil angeschweißt werden.

Großes Potential zeigt die Verschweißung von kohlenstofffaserverstärkten thermoplastischen Kunststoffen (CFK). Beim Schweißen von CFK-Bauteilen ist jedoch die elektrische Leitfähigkeit der Kohlenstoff-Fasern problematisch. In den Fügepartnern können sich kritische elektrische Nebenpfade ausbilden, die die Prozessführung hinsichtlich der Reproduzierbarkeit erschweren. Dies kann in einer Ausgestaltung zuverlässig verhindert werden, bei der das Widerstandselement zumindest eine an die Leiterbahnstruktur angrenzende Isolationsstruktur aufweist, die die Leiterbahnstruktur von dem ersten und/oder zweiten Bauteil elektrisch isoliert, wenn das Widerstandselement zwischen den Fügepartnern angeordnet wird. Die Ausbildung der Isolationsstruktur kann z.B. mittels Mehrfachdruck erfolgen. Beispielsweise kann zunächst eine Isolationsschicht auf dem Werkstück aufgebracht werden, dann die Leiterbahnstruktur auf der Isolationsschicht und eine zweite Isolationsschicht über der Leiterbahnstruktur ausgebildet werden. Die Anschlussabschnitte verbleiben, zumindest teilweise, ohne Isolationsschicht für die Kontaktierung während des Schweißprozesses. Vorzugsweise werden die Isolationsschichten geringfügig breiter als die Leiterbahnstruktur ausgebildet, um eine sichere elektrische Isolation zu gewährleisten. Alternativ kann die Isolationsstruktur auch bei einer auf einer thermoplastischen Folie ausgebildeten Leiterbahnstruktur vorgesehen werden, wobei die Folie Teil der Isolationsstruktur sein kann.

Weiterhin wird eine Bauteilanordnung angegeben mit einem ersten thermoplastischen Bauteil und mindestens einem zweiten thermoplastischen Bauteil und einem Widerstandselement gemäß einer der voranstehend beschriebenen Ausgestaltungen, wobei das Widerstandselement zumindest mit seinem Heizabschnitt in einer Fügezone zwischen den Bauteilen angeordnet ist.

Bezüglich der technischen Wirkungen und Vorteile dieser Bauteilanordnung wird auf die entsprechenden Ausführungen zum Widerstandselement verwiesen, die ebenso für die Bauteilanordnung gelten.

Besonders stabile Fügeverbindungen lassen sich ausbilden, wenn in einer Ausgestaltung die Leitbahnstruktur im Heizabschnitt des Widerstandselements so ausgestaltet ist, dass weniger als 40% der Fügefläche und besonders bevorzugt weniger als 30% der Fügefläche von der Leiterbahnstruktur bedeckt sind. Die große offene Fügefläche von mehr als 60 % und vorzugsweise mehr als 70% begünstigt die Verbindung der Bauteile in der Fügezone.

In einer weiteren Ausgestaltung wird eine besonders einfache Kontaktierung des Widerstandselements ermöglicht, indem die Anschlussabschnitte des Widerstandselements außerhalb der Fügezone angeordnet sind. Durch eine entsprechende Gestaltung der Leiterbahnstruktur ist es problemlos möglich, z.B. frei zugängliche Anschlussabschnitte zu gestalten. Auf eine Durchkontaktierung durch die Bauteile kann verzichtet werden.

Weiterhin wird ein Verfahren zum Widerstandschweißen von mindestens zwei thermoplastischen Bauteilen angegeben, bei dem ein Widerstandselement gemäß einer der voranstehend beschriebenen Ausgestaltungen zwischen einem ersten thermoplastischen Bauteil und mindestens einem zweiten thermoplastischen Bauteil angeordnet wird, so dass zumindest der Heizabschnitt des Widerstandselements in einer Fügezone zwischen den zu fügenden Bauteilen angeordnet ist. Eine elektrische Leistung wird über die Anschlussabschnitte in das Widerstandselement eingebracht, so dass es zu einer Erwärmung des Heizabschnitts und daraus resultierend zu einer Aufschmelzung des thermoplastischen Kunststoffmaterials der Bauteile in der Fügezone kommt.

Während des Schweißens und der nachfolgenden Abkühlung wird auf die Bauteile vorzugsweise ein Fügedruck aufgebracht. Es entsteht eine stoffschlüssige Verbindung der Bauteile sowie des Widerstandelements in der Fügezone.

Die erforderliche elektrische Versorgung wird vorzugsweise durch Gleich- oder Wechselspannungsquellen bereitgestellt und an die Anschlussabschnitte des Widerstandelements angelegt. Durch die Verwendung einer Spannungsquelle kann im Falle des Ausfalls einzelner Leiterbahnen im Heizabschnitt vorteilhafter Weise vermieden werden, dass die verbleibenden Leiterbahnen überlastet werden und ebenfalls ausfallen.

In einer erfindungsgemäßen Ausgestaltung wird ein Widerstandselement verwendet, bei dem die Leiterbahnstruktur auf einer thermoplastischen Folie ausgebildet ist, die einen höheren Schmelzpunkt als die thermoplastischen Materialien der Bauteile aufweist. Bei diesem Verfahren wird die eingebrachte elektrische Leistung nach dem Aufschmelzen des Kunststoffmaterials der Bauteile in der Fügezone erhöht, so dass die thermoplastische Kunststofffolie aufgeschmolzen wird. Die Kunststofffolie wird also erst gegen Ende des Schweißprozesses aufgeschmolzen. Hierdurch kann die Formstabilität und Funktionalität der Leiterbahnstruktur während der Erzeugung des Schmelzbades sichergestellt werden.

Weiterhin wird ein Bauteilverbund angegeben aus einem ersten und mindestens einem zweiten thermoplastischen Kunststoffbauteil, die in einer Fügezone miteinander widerstandsverschweißt sind, bei dem in der Fügezone eine Leiterbahnstruktur als Widerstandselement angeordnet ist. Der Bauteilverbund kann insbesondere nach dem voranstehend beschriebenen Verfahren und/oder unter Verwendung des voranstehend beschriebenen Widerstandselements ausgebildet werden und erzielt insofern die gleichen technischen Wirkungen und Vorteile.

Die Erfindung eignet sich zum Verschweißen von thermoplastischen Bauteilen, d.h. Bauteilen aus thermoplastischen Kunststoffen mit oder ohne Faserverstärkung. Insbesondere können die Bauteile Faserverstärkungen aus Kohlenstofffasern oder Glasfasern enthalten. Mit der Erfindung können ausreichend feste Schweißverbindungen erzielt werden, so dass die Bauteile insbesondere Strukturbauteile von Fahrzeugkarosserien sein können.

Mit Hilfe der vorgeschlagenen Erfindung lassen sich vielfältige Vorteile erzielen. Es wird eine hohe Flexibilität und Freiheit in der Druckbildgestaltung des Widerstandselements bereitgestellt. In Abhängigkeit des Druckbilds ist z.B. durch Variation der Leiterbahndichte, Leiterbahnbreite und -dicke, etc., innerhalb der Fügezone eine thermisch funktionale Ausgestaltung mit gezieltem Wärmeeintrag realisierbar. Die parallele Verschweißung mehrerer Fügeflächen durch serielle Anordnung der Schweißflächen bzw. Heizabschnitte ist möglich. Die Kurzschluss-Problematik bei kohlenstofffaserverstärkten Bauteilen kann vermieden werden durch Herstellen eines Widerstandelements plus Isolationsschichten im Mehrfachdruck. Zudem lassen sich auch dreidimensionale Fügeflächen realisieren. Geometrische Verzerrungen an gekrümmten Fügeflächen können vermieden werden, wodurch konstante Leistungsdichten über die Fügefläche erzielbar sind. Im Service- und Reparaturfall ist ein Wiederöffnen der Fügestelle zur Trennung der Fügepartner durch erneuten Leistungseintrag ohne großflächige Zerstörung der Fügeflächen möglich. Die Widerstandselemente können mit einer hohen Reproduzierbarkeit hergestellt werden durch eine genaue Widerholungsrate des Druckbilds der Leiterbahnstruktur. Es lassen sich alle elektrisch leitenden, druckbaren Werkstoffe zur Erzeugung der Leiterbahnstruktur verwenden. Zudem können elektrische Kontaktstellen bzw. Kontaktabschnitte in beliebiger Entfernung von der Fügestelle / den Fügestellen platziert werden und für mehrere Fügestellen zusammenfasst werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele. Sofern in dieser Anmeldung der Begriff "kann" verwendet wird, handelt es sich sowohl um die technische Möglichkeit als auch um die tatsächliche technische Umsetzung.

Im Folgenden werden Ausführungsbeispiele an Hand der beiliegenden Zeichnungen erläutert. Darin zeigen:
- Figur 1A: eine Schnittansicht einer Bauteilanordnung mit einem nicht erfindungsgemäßen Widerstandselement,
- Figur 1B:: eine Schnittansicht einer Bauteilanordnung mit einem nicht erfindungsgemäßen Widerstandselement, mit
- Figur 1C:: eine Schnittansicht einer Bauteilanordnung mit Widerstandselement gemäß einem dritten Ausführungsbeispiel der Erfindung,
- Figur 2A bis 2D:: Draufsichten von beispielhaften Leiterbahnstrukturen und
- Figur 2E:: eine Draufsicht einer Leiterbahnstruktur mit seriell geschalteten Heizabschnitten für mehrere Schweißzonen.

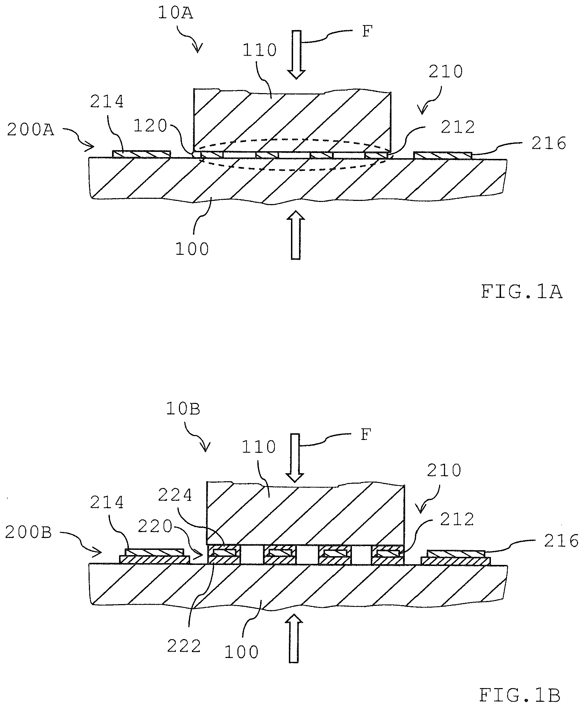

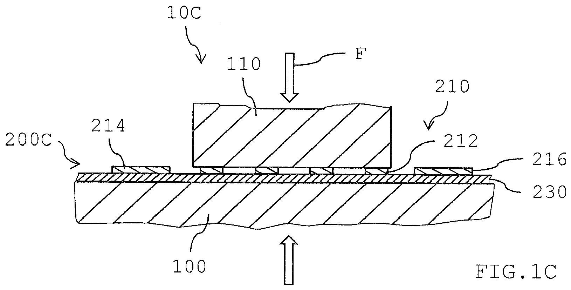

Figur 1 zeigt eine Bauteilanordnung zum Widerstandsschweißen mit einem nicht erfindungsgemäßen Widerstandselement.

Die Bauteilanordnung 10A umfasst ein erstes Bauteil 100 aus thermoplastischem Kunststoff, das mit einem zweiten Bauteil 110 aus thermoplastischem Kunststoff verschweißt werden soll. Hierzu wird zwischen dem erstem Bauteil 100 und dem zweiten Bauteil 110 ein Widerstandselement 200A angeordnet. Das Widerstandselement 200A beinhaltet eine Leiterbahnstruktur 210, die auf dem ersten Bauteil 100 ausgebildet ist. Die Leiterbahnstruktur 210 umfasst einen Heizabschnitt 212, der innerhalb der Fügezone 120 angeordnet ist, sowie Anschlussabschnitte 214 und 216. Die Anschlussabschnitte 214 und 216 sind außerhalb der Fügezone 120 an dem ersten Bauteil 100 angeordnet. Für den Schweißprozess wird elektrische Leistung über die Anschlussabschnitte 214 und 216 in das Widerstandselement 200A eingebracht, wodurch sich der Heizabschnitt 212 erwärmt und so zu einer Aufschmelzung des umliegenden thermoplastischen Materials von erstem und zweitem Bauteil 100 und 110 führt. Durch Aufbringen eines Fügedrucks F auf die Fügepartner und Erkalten der Schmelze wird eine feste stoffschlüssige Verbindung ausgebildet.

Figur 1B zeigt eine Schnittansicht einer Bauteilanordnung 10B mit einem nicht erfindungsgemäßen Widerstandselement 200B.

Das Widerstandselement 200B eignet sich insbesondere zum Verschweißen von Bauteilen aus kohlenstofffaserverstärkten Kunststoffen, da unerwünschte Nebenstromschlüsse zuverlässig verhindert werden können.

Das Widerstandselement 200B weist ebenso wie das in Figur 1A gezeigte Widerstandselement 200A eine Leiterbahnstruktur 210 mit Heizabschnitt 212 und Anschlussabschnitten 214, 216 auf. Jedoch ist die Leiterbahnstruktur 210 durch eine Isolationsstruktur 220 elektrisch von den Bauteilen isoliert. Genauer gesagt ist eine erste Isolationsschicht 222 zwischen der Leiterbahnstruktur 210 und dem erstem Bauteil 100 angeordnet und eine zweite Isolationsschicht 224 ist zwischen der Leiterbahnstruktur 210 und dem zweitem Bauteil 110 angeordnet. Die Isolationsstruktur 222 ist mit ähnlichem Druckbild wie die Leiterbahnstruktur 210 ausgebildet, allerdings geringfügig breiter, so dass eine elektrische Isolation gegeben ist. Das Ausbilden der Isolationsschichten und Leiterbahnstruktur erfolgt vorzugsweise mittels mehrstufigem Druckverfahren. Hierzu wird vor dem Ausbilden der Leiterbahnstruktur 210 zunächst lokal in den Leiterbahnbereichen die erste Isolationsschicht 222 aufgetragen. Hierauf wird die Leiterbahnstruktur 210 ausgebildet und in einem anschließenden Schritt mittels zweiter Isolationsschicht 224 bedeckt.

Figur 1C zeigt eine Bauteilanordnung 10C mit einem Widerstandselement 200C gemäß einem weiteren Ausführungsbeispiel der Erfindung.

Das Widerstandselement 200C unterscheidet sich von dem zu Figur 1A beschriebenen Widerstandselement 200A dadurch, dass die Leiterbahnstruktur 210 nicht unmittelbar auf dem ersten Bauteil 100 ausgebildet wird, sondern auf einer Folie 230 aus einem thermoplastischen Kunststoff. Die Kunststofffolie 230 dient dabei als flexibles Trägermaterial für die Leiterbahnstruktur 210. Das Ausbilden der Leiterbahnstruktur 210 auf der Folie 230 erfolgt vorzugsweise durch ein Druckverfahren. Vorteilhafter Weise kann das Bedrucken der Folie 230 im ebenen Zustand erfolgen. Die bedruckte Folie 230 wird in einem nachfolgenden Schritt auf das erste Bauteil 100 aufgelegt und kann optional über eine Adhäsions- oder Klebeschicht an diesem fixiert werden. Obwohl in Figur 1C eine ebene Fügefläche dargestellt ist, kann die auf Folie gedruckte Leiterbahnstruktur ebenso auf dreidimensionalen Fügestrukturen abgelegt werden. Somit wird ein einfaches Verfahren zum Verschweißen dreidimensionaler Fügeflächen bereitgestellt. Zudem kann die Folie 230 im Schweißprozess als Schweißzusatzwerkstoff herangezogen werden, um in der Fügenaht ausreichend Kunststoffmatrix zur Verfügung zu stellen.

Die thermoplastische Folie 230 ist aus einem Kunststoff ausgebildet, der einen höheren Schmelzpunkt aufweist, als das Kunststoffmaterial der ersten und zweiten Bauteile 100 und 110. Dadurch begegnet man einerseits der Kurzschluss-Problematik bei dem Verschweißen von Kohlenstofffaserverstärkten Bauteilen. Zudem sichert der höhere Schmelzpunkt die Formstabilität der Leiterbahnstruktur 210 bei Schmelzbeginn der Fügepartner.

In einer in den Figuren nicht dargestellten, weiteren Ausführungsform wird eine zweite thermoplastische Folie als Deckschicht auf der Leiterbahnstruktur von Fig. 1C angeordnet, so dass die Leiterbahnstruktur 210 zwischen erster und zweiter thermoplastischer Folie angeordnet ist. Hierdurch wird die Leiterbahnstruktur zu beiden Fügepartnern hin elektrisch isoliert.

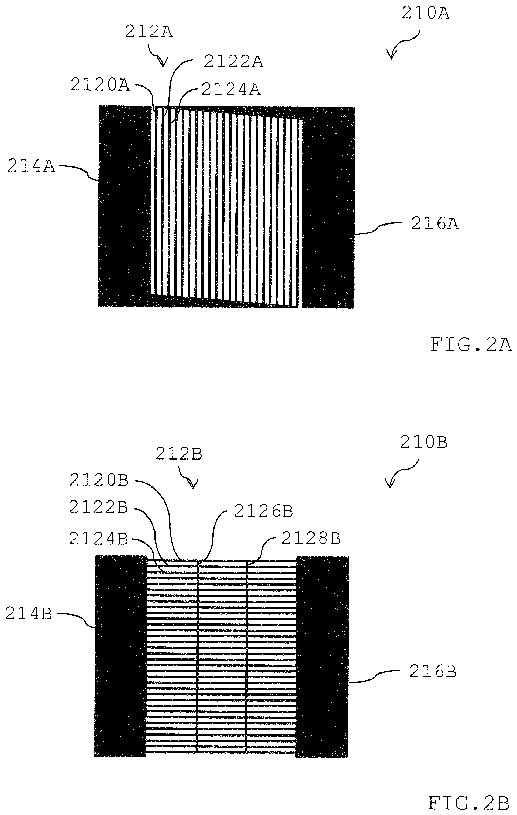

Die zur Verfügung stehenden Herstellverfahren zur Ausbildung von Leiterbahnstrukturen ermöglichen eine große Freiheit bei der Formgebung der Leiterbahnstruktur. Die Figuren 2A bis 2E zeigen Leiterbahnstrukturen von Widerstandselementen in der Draufsicht zur Veranschaulichung beispielhafter Ausgestaltungen.

Die in Figur 2A dargestellte Leiterbahnstruktur 210A weist einen Heizabschnitt 212A mit einer Vielzahl von Leiterbahnen 2120A, 2122A, 2124A, ... auf, die parallel zueinander angeordnet und gleichmäßig auf einer Parallelogrammförmigen Fügefläche verteilt sind. Die Leiterbahnen 2120A, 2122A, 2124A, ... sind über einen ersten Anschlussabschnitt 214A und einen zweiten Anschlussabschnitt 216A parallel miteinander verschaltet. Die Anschlussabschnitte verjüngen sich im Übergangsbereich zu den Leiterbahnen keilförmig zur widerstandsoptimierten Stromverteilung auf die Leiterbahnen.

Diese Struktur ermöglicht einen gleichmäßigen Leistungseintrag in die einzelnen Leiterbahnen 2120A, 2122A, 2124A, .... Durch die Vielzahl parallel geschalteter Leiterbahnen ist auch bei Ausfall einzelner Leiterbahnen eine gleichmäßige Erwärmung der Fügefläche gewährleistet.

Figur 2B zeigt eine alternative Ausgestaltung einer Leiterbahnstruktur 210B zur weiteren Optimierung gegen den Ausfall einzelner Leiterbahnen. Im Heizbereich 212B sind eine Vielzahl von geraden Leiterbahnen 2120B, 2122B, 2124B, ... parallel zueinander zwischen zwei rechtwinkligen Anschlussabschnitten 214B und 216B ausgebildet. Die Leiterbahnen 2120B, 2122B, 2124B, ... sind durch zwei querverbindende Leiterbahnen 2126B und 2128B rechtwinklig verbunden. So kann bei Unterbrechung einer der Leiterbahnen 2120B, 2122B, 2124B, ... die Länge des nicht bestromten Abschnitts dieser Leiterbahn reduziert werden.

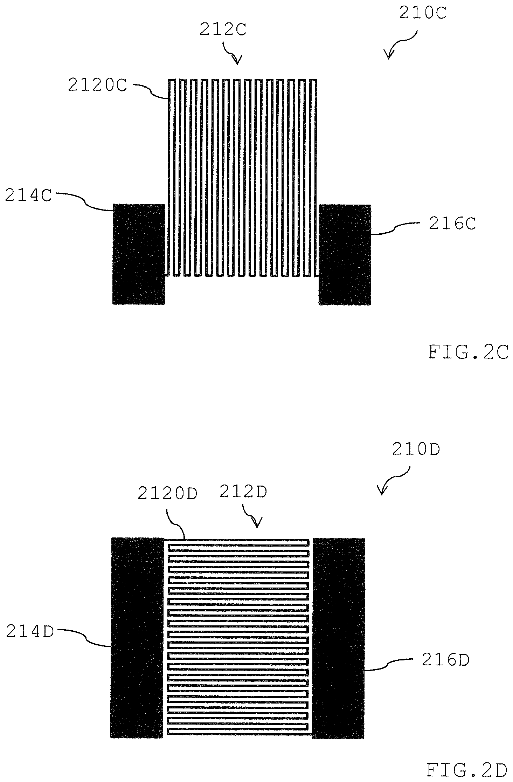

Figur 2C und 2D zeigen jeweils eine Leiterbahnstruktur 210C bzw. 210D, die im Heizabschnitt 212C bzw. 212D jeweils nur eine einzige mäanderförmige Leiterbahn 2120C bzw. 2120D aufweist.

Alternativ können die Leiterbahnen im Heizabschnitt auch in anderer Anzahl und anderen geometrischen Formen, z.B. schneckenförmig, kreisförmig etc. angeordnet werden. Die Verschaltung kann individuell entsprechend der Anforderungen der Fügefläche gewählt werden zur Erzeugung des gewünschten Wärmebildes. Die Größe und Anordnung der Anschlussbereiche kann variiert werden zur Erzielung weiterer Effekte, wie z.B. leichtere Kontaktierung, gezielte Wärmeabfuhr etc.

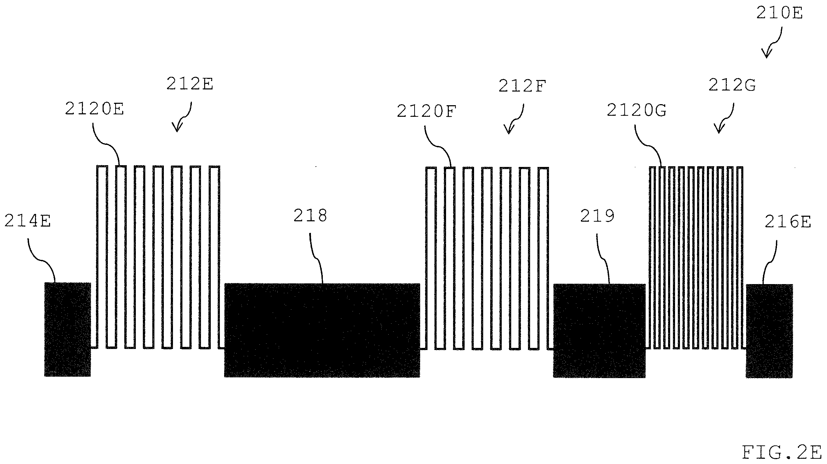

Durch serielles Verbinden mehrere Heizabschnitte ist es möglich, zeitgleich mehrere Schweißungen (an verschiedenen Bauteilen oder an verschiedenen Stellen derselben Bauteile) vorzunehmen. Figur 2E zeigt eine Leiterbahnstruktur 210E mit drei Heizabschnitten 212E, 212F und 212G, die durch Verbindungsabschnitte 218 und 219 miteinander verbunden sind und über gemeinsame Anschlussabschnitte 214E und 216E kontaktiert werden. Die Verbindungsabschnitte 218 und 219 sind so ausgelegt, dass in ihnen während des Aufbringens der Schweißenergie keine nennenswerte Erwärmung durch Joule'sche Verluste stattfindet, insbesondere bleibt die Erwärmung der Verbindungsabschnitte durch Joule'sche Verluste unterhalb der Schmelztemperatur der Kunststoffe im Fügebereich.

Obwohl Figur 2E drei Heizabschnitte zeigt, können auch nur zwei oder mehr als drei Heizabschnitte vorgesehen sein. Ebenso können andere Leiterbahnanordnungen als die gezeigten mäanderförmigen Einzelleiterbahnen 2120E, 2120F und 2120F vorgesehen sein.

Um einer Wärmeabfuhr in den Randbereichen der Heizabschnitte entgegenzuwirken, können die in den Figuren 2A bis 2E gezeigten Heizabschnitte in den Randbereichen so gestaltet sein, dass sie sich dort lokal stärker erwärmen. Hierzu können die den Anschlussabschnitten zugewandten Randbereiche der Leiterbahnstruktur vorzugsweise einen verringerten Querschnitt aufweisen, z.B. durch eine geringere Leiterbahndicke. Alternativ kann dieser Effekt ebenso durch Variation der Abstände oder der Breite der Leiterbahnen erzielt werden.

Obwohl in den Ausführungsbeispielen ebene Widerstandselemente gezeigt sind, liegt es insbesondere im Fokus der Erfindung, dass die Widerstandselemente mit den Leiterbahnstrukturen auf dreidimensionalen Fügeflächen angeordnet bzw. ausgebildet werden und in ihrer Ausgestaltung entsprechend optimiert sind.

Die Ausführungsbeispiele sind nicht maßstabsgetreu und nicht beschränkend. Abwandlungen im Rahmen des fachmännischen Handelns sind möglich.

### Bezugszeichenliste

- 10A, 10B, 10C: Bauteilanordnung
- 100,110: Bauteil
- 120: Fügezone
- 200A, 200B, 200C: Widerstandselement
- 210, 210A, 210B, 210C, 210D, 210E: Leiterbahnstruktur
- 212, 212A bis 212G: Heizabschnitt
- 214, 214A bis 214E, 216, 216A bis 216E: Anschlussabschnitt
- 218, 219: Verbindungsabschnitt
- 220: Isolationsstruktur
- 222,224: Isolationsschicht
- 230: Kunststofffolie
- 2120A bis 2120G, 2122A, 2122B, 2124A, 2124B, 2126B, 2128B: Leiterbahnen
- 300: Fügefläche
- F: Fügedruck

## Patentansprüche

1. Bauteilanordnung zur Herstellung einer Schweißverbindung in einer Fügezone (120), mit
einem ersten thermoplastischen Bauteil (100) und mindestens einem zweiten thermoplastischen Bauteil (110) und einem Widerstandselement (200C) mit einer auf einer thermoplastischen Kunststofffolie (230) ausgebildeten Leiterbahnstruktur (210), die zumindest einen Heizabschnitt (212) und Anschlussabschnitte (214, 216) aufweist, wobei der Heizabschnitt (212) durch Einbringen einer elektrischen Energie erwärmt werden kann, so dass umgebendes Kunststoffmaterial aufgeschmolzen werden kann,
wobei das Widerstandselement zumindest mit seinem Heizabschnitt (212) in der Fügezone zwischen den Bauteilen angeordnet ist,
**dadurch gekennzeichnet, dass**
die thermoplastische Folie (230) einen höheren Schmelzpunkt als die thermoplastischen Materialien der Bauteile (100; 110) aufweist.

2. Bauteilanordnung nach Patentanspruch 1, bei der
die Leiterbahnstruktur (210) mittels Druckverfahren ausgebildet wurde.

3. Bauteilanordnung nach einem der vorangehenden Patentansprüche, bei der
der Heizabschnitt (212A; 212B) zwei oder mehrere parallel geschaltete Leiterbahnen (2120A, 2122A, 2124A; 2120B, 2122B, 2124B) aufweist.

4. Bauteilanordnung nach Patentanspruch 3, bei der
der Heizabschnitt (212B) weiterhin mindestens eine Querverbindung (2126B; 2128B) zwischen den parallel geschalteten Leiterbahnen (2120B, 2122B, 2124B) aufweist.

5. Bauteilanordnung nach einem der vorangehenden Patentansprüche, bei der
die Leiterbahnstruktur (210) im Heizabschnitt (212) so ausgebildet ist, dass die Wärmeentwicklung in einem Randgebiet des Heizabschnitts (212) gegenüber der Heizabschnittmitte erhöht ist.

6. Bauteilanordnung nach einem der vorangehenden Patentansprüche, bei der
zwei oder mehr seriell geschaltete Heizabschnitte (212E, 212F, 212G) aufweist.

7. Bauteilanordnung nach einem der vorangehenden Patentansprüche, bei der
weiterhin zumindest eine an die Leiterbahnstruktur (210) angrenzende Isolationsstruktur (220) aufweist, die so ausgebildet ist, dass sie die Leiterbahnstruktur (210) von dem ersten und/oder zweiten Bauteil (100, 110) elektrisch isoliert, wenn das Widerstandselement zwischen den Fügepartnern angeordnet ist.

8. Bauteilanordnung nach einem der vorangehenden Patentansprüche, bei der
die Bauteile kohlenstofffaserverstärkte Bauteile sind.

9. Bauteilanordnung nach einem der vorangehenden Patentansprüche, bei der
die Bauteile Strukturbauteile einer Fahrzeugkarosserie sind.

10. Bauteilanordnung nach einem der vorangehenden Patentansprüche, wobei der Heizabschnitt (212) der Leiterbahnstruktur (210) weniger als 40% und insbesondere weniger als 30% der Fügefläche bedeckt.

11. Bauteilanordnung nach einem der vorangehenden Patentansprüche, wobei die Anschlussabschnitte (214, 216) des Widerstandselements (200C) außerhalb der Fügezone angeordnet sind.

12. Verfahren zum Widerstandsschweißen von mindestens zwei thermoplastischen Bauteilen, bei dem
ein Widerstandselement (200C) mit einer auf einer thermoplastischen Kunststofffolie (230) ausgebildeten Leiterbahnstruktur (210), die zumindest einen Heizabschnitt (212) und Anschlussabschnitte (214, 216) aufweist, wobei der Heizabschnitt (212) durch Einbringen einer elektrischen Energie erwärmt werden kann, so dass umgebendes Kunststoffmaterial aufgeschmolzen werden kann, zwischen einem ersten thermoplastischen Bauteil (100) und mindestens einem zweiten thermoplastischen Bauteil (110) angeordnet wird, so dass zumindest der Heizabschnitt (212) des Widerstandselements (200C) in einer Fügezone (120) zwischen den zu fügenden Bauteilen angeordnet ist, und
eine elektrische Leistung über die Anschlussabschnitte (214; 216) in das Widerstandselement (200C) eingebracht wird, so dass es zu einer Erwärmung des Heizabschnitts (210) und daraus resultierend zu einer Aufschmelzung des thermoplastischen Kunststoffmaterials der Bauteile (100; 110) in der Fügezone (120) kommt,
**dadurch gekennzeichnet, dass**
die thermoplastische Folie (230) einen höheren Schmelzpunkt als die thermoplastischen Materialien der Bauteile (100; 110) aufweist, und dass die eingebrachte Leistung nach dem Aufschmelzen des Kunststoffmaterials der Bauteile (100; 110) in der Fügezone (120) erhöht wird, so dass die thermoplastische Kunststofffolie (230) aufgeschmolzen wird.

13. Verfahren nach Patentanspruch 12, mit dem
eine Bauteilanordnung nach einem der Patentansprüche 2 bis 7 geschweißt wird.

14. Verfahren nach Patentanspruch 12 oder 13,
bei dem die Bauteile kohlenstofffaserverstärkte Bauteile sind.

15. Verfahren nach einem der Patentansprüche 12 bis 14,
bei dem die Bauteile Strukturbauteile einer Fahrzeugkarosserie sind.

## Claims

1. A component arrangement for producing a welded joint in a joining zone (120), with
a first thermoplastic component (100) and at least a second thermoplastic component (110) and a resistance element (200C) with a conductive path structure (210) formed on a thermoplastic plastics film (230), which structure has at least one heating portion (212) and connection portions (214, 216), wherein the heating portion (212) can be heated by introducing electrical energy, so that surrounding plastics material can be melted,
wherein the resistance element, at least with its heating portion (212), is arranged in the joining zone between the components,
**characterised in that**
the thermoplastic film (230) has a higher melting point than the thermoplastic materials of the components (100; 110).

2. A component arrangement according to Claim 1, in which
the conductive path structure (210) has been formed by means of printing methods.

3. A component arrangement according to one of the preceding claims, in which
the heating portion (212A; 212B) has two or more conductive paths (2120A, 2122A, 2124A; 2120B, 2122B, 2124B) which are connected in parallel.

4. A component arrangement according to Claim 3, in which the heating portion (212B) furthermore has at least one transverse connection (2126B; 2128B) between the conductive paths (2120B, 2122B, 2124B) which are connected in parallel.

5. A component arrangement according to one of the preceding claims, in which
the conductive path structure (210) in the heating portion (212) is formed such that the heat generation in an edge region of the heating portion (212) is increased relative to the middle of the heating portion.

6. A component arrangement according to one of the preceding claims, in which
has two or more heating portions (212E, 212F, 212G) which are connected in parallel.

7. A component arrangement according to one of the preceding claims, in which
furthermore has at least one isolating structure (220) adjoining the conductive path structure (210) which is formed such that it electrically isolates the conductive path structure (210) from the first and/or second component (100, 110) if the resistance element is arranged between the joining components.

8. A component arrangement according to one of the preceding claims, in which
the components are carbon-fibre reinforced components.

9. A component arrangement according to one of the preceding claims, in which
the components are structural components of a vehicle body.

10. A component arrangement according to one of the preceding claims, wherein the heating portion (212) of the conductive path structure (210) covers less than 40% and especially less than 30% of the joint surface.

11. A component arrangement according to one of the preceding claims, wherein the connection portions (214, 216) of the resistance element (200C) are arranged outside the joining zone.

12. A method for resistance welding of at least two thermoplastic components, in which
a resistance element (200C) with a conductive path structure (210) formed on a thermoplastic plastics film (230), which structure has at least one heating portion (212) and connection portions (214, 216), wherein the heating portion (212) can be heated by introducing electrical energy, so that surrounding plastics material can be melted, is arranged between a first thermoplastic component (100) and at least a second thermoplastic component (110), so that at least the heating portion (212) of the resistance element (200C) is arranged in a joining zone (120) between the components to be joined, and
electric power is introduced into the resistance element (200C) by way of the connection portions (214; 216), so that heating of the heating portion (210) and, resulting therefrom, melting of the thermoplastic plastics material of the components (100; 110) in the joining zone (120) occurs,
**characterised in that**
the thermoplastic film (230) has a higher melting point than the thermoplastic materials of the components (100; 110), and **in that**
the power introduced after the melting of the plastics material of the components (100; 110) in the joining zone (120) is increased, so that the thermoplastic plastics film (230) is melted.

13. A method according to Claim 12, with which
a component arrangement according to one of Claims 2 to 7 is welded.

14. A method according to Claim 12 or Claim 13,
in which the components are carbon-fibre reinforced components.

15. A method according to one of Claims 12 to 14,
in which the components are structural components of a vehicle body.

## Revendications

1. Agencement de composants destiné à la fabrication d'une liaison soudée dans une zone de jointure (120) comprenant :
un premier composant thermoplastique (100) et au moins un second composant thermoplastique (110) ainsi qu'un élément de résistance (200C) ayant une structure de piste conductrice (210) formée sur un film en matériau synthétique thermoplastique (230) qui comporte au moins un segment de chauffage (212) et un segment de connexion (214, 216), le segment de chauffage pouvant être chauffé par apport d'énergie électrique de sorte que le matériau synthétique environnant puisse être fondu,
l'élément de résistance étant situé au moins par son segment de chauffage (212) dans la zone de jointure entre les composants,
**caractérisé en ce que**
le film thermoplastique (230) a un point de fusion plus élevé que le matériau thermoplastique des composants (100, 110).

2. Agencement de composants conforme à la revendication 1,
dans lequel la structure de piste conductrice (210) a été formée par un procédé d'impression.

3. Agencement de composants conforme à l'une des revendications précédentes,
dans lequel le segment de chauffage (212A ; 212B) comporte au moins deux pistes conductrices (2120A, 2122A, 2124A, 2120B, 2122B, 2124B) branchées en parallèle.

4. Agencement de composants conforme à la revendication 3,
dans lequel le segment de chauffage (212B) comporte en outre au moins une liaison transversale (2126B, 2128B) entre les pistes conductrices branchées en parallèle (2120B, 2122B, 2124B).

5. Agencement de composants conforme à l'une des revendications précédentes,
selon lequel la structure de piste conductrice (210) est réalisée dans le segment de chauffage (212) de sorte que le dégagement de chaleur soit augmenté dans la zone du bord du segment de chauffage (212) par rapport à la partie médiane de ce segment de chauffage.

6. Agencement de composants conforme à l'une des revendications précédentes,
dans lequel il est prévu au moins deux segments de chauffage (212E, 212F, 212G) branchés en série.

7. Agencement de composants conforme à l'une des revendications précédentes comportant en outre au moins une structure d'isolation (220) voisine de la structure de piste conductrice (210) qui est réalisée de façon à isoler électriquement la structure de piste conductrice (210) du premier composant et/ou du second composant (100, 110) lorsque l'élément de résistance est situé entre les deux partenaires de jointure.

8. Agencement de composants conforme à l'une des revendications précédentes,
dans lequel les composants sont des composants renforcés par des fibres de carbone.

9. Agencement de composants conforme à l'une des revendications précédentes,
dans lequel les composants sont des composants de structure d'une carrosserie de véhicule.

10. Agencement de composants conforme à l'une des revendications précédentes,
dans lequel le segment de chauffage (212) de la structure de piste conductrice (210) recouvre moins de 40% et en particulier moins de 30% de la surface de jointure.

11. Agencement de composants conforme à l'une des revendications précédentes,
dans lequel les segments de connexion (214, 216) de l'élément de résistance (200C) sont situés à l'extérieur de la zone de jointure.

12. Procédé de soudage par résistance d'au moins deux composants thermoplastiques selon lequel :
un élément de résistance (200C) comportant une structure de piste conductrice (210) formée sur un film en matériau synthétique thermoplastique (230) ayant au moins un segment de chauffage (212) et un segment de connexion (214, 216), le segment de chauffage (212) pouvant être chauffé par apport d'énergie électrique de sorte que le matériau synthétique environnant puisse être fondu, est installé entre un premier composant thermoplastique (100) et au moins un second composant thermoplastique (110) de façon qu'au moins le segment de chauffage (212) de l'élément de résistance (200C) soit situé dans une zone de jointure (120) entre les composants à joindre, et
une puissance électrique est fournie à l'élément de résistance (200C) par l'intermédiaire des segments de connexion (214, 216) de façon à obtenir un chauffage du segment de chauffage (210) et, par suite, une fusion du matériau synthétique thermoplastique des composants (100, 110) dans la zone de jointure (120),
**caractérisé en ce que**
le film thermoplastique (230) a un point de fusion supérieur à celui des matériaux thermoplastiques des composants (100, 110), et la puissance fournie est augmentée après la fusion du matériau synthétique des composants (100, 110) dans la zone de jonction (120) de sorte que le film en matériau synthétique thermoplastique (230) soit fondu.

13. Procédé conforme à la revendication 12,
permettant de fondre un agencement de composants conforme à l'une des revendications 2 à 7.

14. Procédé conforme à la revendication 12 ou 13,
selon lequel les composants sont des composants renforcés par des fibres de carbone.

15. Procédé conforme à l'une des revendications 12 à 14,
selon lequel les composants sont des composants de structure d'une carrosserie de véhicule.
